(19) Europäisches Patentamt
European Patent Office
Office européen des brevets

(11) **EP 3 839 545 A1**

(12) **EUROPÄISCHE PATENTANMELDUNG**

(43) Veröffentlichungstag:
**23.06.2021  Patentblatt 2021/25**

(51) Int Cl.:
**G01R 33/483** *(2006.01)*          **G01R 33/561** *(2006.01)*
**G01R 33/565** *(2006.01)*

(21) Anmeldenummer: **19216974.6**

(22) Anmeldetag: **17.12.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
**KH MA MD TN**

(71) Anmelder: **Siemens Healthcare GmbH**
**91052 Erlangen (DE)**

(72) Erfinder: **Stemmer, Alto**
**91054 Erlangen (DE)**

(54) **ARTEFAKTREDUKTION BEI DER SPIN-ECHO-MR-BILDGEBUNG DES ZENTRALEN NERVENSYSTEMS**

(57)    Es wird ein Verfahren zur Ansteuerung eines Magnetresonanzbildgebungssystems zur Erzeugung von Magnetresonanzbilddaten (BD) eines Untersuchungsobjekts (P), bei dem Magnetresonanzrohdaten (RD) erfasst werden, beschrieben. Das Verfahren umfasst das Ausspielen mindestens einer Spin-Echo-Pulssequenz oder einer Turbo-Spin-Echo-Pulssequenz. Das Verfahren umfasst einen Anregungsvorgang, wobei ein RF-Anregungspuls (1) eingestrahlt wird, mit dem ein abzubildender Bereich angeregt wird, und der abzubildende Bereich durch einen Selektionsgradienten (4) definiert wird. Teil des Verfahrens ist auch ein Refokussierungsvorgang, bei dem ein RF-Refokussierungspuls (2) eingestrahlt wird, mit dem ein Refokussierungsbereich beeinflusst wird, und der zu refokussierende Bereich mit einem Selektionsgradienten (5) definiert wird. Weiterhin umfasst das Verfahren einen Auslesevorgang zur Akquisition von Magnetresonanzrohdaten (RD), welcher das Empfangen von HF-Signalen (3) umfasst. Im Rahmen des Anregungsvorgangs und des Refokussierungsvorgangs wird die räumliche Ausdehnung des Anregungsbereichs signifikant verschieden von der räumlichen Ausdehnung des Refokussierbereichs gewählt. Es wird auch eine Ansteuersequenz (30, 40) beschrieben. Zudem wird auch ein Magnetresonanzbildgebungssystem (70) beschrieben.

FIG 3

EP 3 839 545 A1

**Beschreibung**

Die Erfindung betrifft ein Verfahren zur Ansteuerung eines Magnetresonanzbildgebungssystems zur Erzeugung von Magnetresonanzbilddaten eines Untersuchungsobjekts, bei dem Magnetresonanzrohdaten erfasst werden. Des Weiteren betrifft die Erfindung eine Ansteuersequenz zur Ansteuerung eines Magnetresonanzbildgebungssystems. Schließlich betrifft die Erfindung ein Magnetresonanzbildgebungssystem.

Bei der Erzeugung von Magnetresonanzaufnahmen wird der zu untersuchende Körper einem relativ hohen Grundmagnetfeld, beispielsweise von 1,5 Tesla, 3 Tesla, oder bei neueren Hochmagnetfeldanlagen sogar von 7 Tesla und höher, ausgesetzt. Es wird dann mit einer geeigneten Antenneneinrichtung ein hochfrequentes Anregungssignal ausgesendet, welches dazu führt, dass die Kernspins bestimmter durch dieses Hochfrequenzfeld in dem gegebenen Magnetfeld resonant angeregter Atome um einen bestimmten Flipwinkel gegenüber den Magnetfeldlinien des Grundmagnetfelds verkippt werden. Das bei der Relaxation der Kernspins abgestrahlte Hochfrequenzsignal, das sog. Magnetresonanzsignal, wird dann mit geeigneten Antenneneinrichtungen, welche auch identisch mit der Sendeantenneneinrichtung sein können, aufgefangen. Die so akquirierten Rohdaten werden nach Demodulation und Digitalisierung schließlich genutzt, um die gewünschten Bilddaten zu rekonstruieren. Zur Ortskodierung werden dem Grundmagnetfeld während des Sendens und des Auslesens bzw. Empfangens der Hochfrequenzsignale sowie in den Zeitintervallen zwischen Senden und Empfangen, bzw. Empfangen und erneutem Senden jeweils definierte Magnetfeldgradienten überlagert.

Üblicherweise setzt sich eine Magnetresonanzaufnahme aus einer Vielzahl von einzelnen Teilmessungen zusammen, bei denen Rohdaten aus verschiedenen Schichten des Untersuchungsobjekts aufgenommen werden, um daraus anschließend Volumenbilddaten zu rekonstruieren. Eine Anwendung der MR-Bildgebung betrifft die Abbildung der Wirbelsäule. Im Rückenmark der Wirbelsäule fließt eine sogenannte Gehirn-Rückenmarksflüssigkeit, auch als Cerebrospinalflüssigkeit bezeichnet (abgekürzt mit CSF). Diese Flüssigkeit ist farblos, steht mit der Gewebsflüssigkeit des Gehirns in Verbindung und ist ihr in der Zusammensetzung sehr ähnlich. Diese Flüssigkeit wird von speziellen Epithelzellen der Adergeflechte der Hirnkammern gebildet. Die ständig neu produzierte Cerebrospinalflüssigkeit wird über das Rückenmark zum Lymphsystem abgeleitet und dort abgebaut. CSF weist eine lange Tl-Relaxationszeit und eine lange T2-Relaxationszeit auf. Als T1-Relaxationszeit soll wie üblich die Relaxationszeit der Längs-Magnetisierung in z-Richtung, also in Richtung des Grundmagnetfelds verstanden werden. Unter einer T2-Relaxationszeit soll wie üblich die Relaxation der Quer-Magnetisierung verstanden werden. Wird nun beispielsweise eine zweidimensionale axiale T2-gewichtete Bildgebung der Wirbelsäule mit einer 2D-Turbo-Spin-Echo-Pulssequenz durchgeführt, so wird die CSF aufgrund der langen T2-Relaxationszeit sehr hell dargestellt. Aufgrund der Bewegung der CSF im Takt der Herzbewegung ergeben sich Artefakte, welche eine Interpretation der diagnostischen Bilder erschweren. Die physikalische Ursache der Flussartefakte ist z.B. in dem Artikel "Normal MRI Appearance and Motion-Related Phenomena of CSF" von Christopher Lisanti et al., erschienen in AJR: 188, März 2007, Seite 716-725, beschrieben. In dem Artikel werden mehrere Ursachen beschrieben. Die vorliegende Erfindung adressiert dabei das in dem Artikel als "time-of flight (TOF) loss" beschriebene Phänomen. Ursächlich für den "time-of flight (TOF) loss" ist, dass fließendes bzw. pulsierendes CSF, das sich zur Zeit der Anregung in der jeweils angeregten und refokussierten Schicht befunden hat, in der Zeit zwischen Anregung und Refokussierung die Schicht verlässt, damit nicht refokussiert wird und demzufolge in den nachfolgend generierten Echos auch keinen Signalbeitrag liefert. Frisches in die Schicht einfließendes CSF wiederum hat den Anregungspuls nicht "gesehen" und liefert demzufolge auch keinen Signalbeitrag.

Eine Turbo-Spin-Echo-Sequenz besteht aus einem RF-Anregungspuls und einer Serie von Refokussierpulsen die mehrere Echos erzeugen. Jedes Echo wird in der Regel mit Hilfe von Phasenkodier- und Frequenzkodier-Gradienten anders räumlich kodiert, so dass z.B. mehrere k-Raum-Zeilen nach einem Anregungspuls ausgelesen werden können. Unter einer 2-dimensionalen Turbo-Spin-Echo-Sequenz wird hier eine Turbo-Spin-Echo-Sequenz verstanden, bei der die Phasen-Kodierung nur in eine räumliche Richtung erfolgt, die senkrecht zur Frequenzkodierung und senkrecht zur Schichtselektionsrichtung ist. Bei einer 3-dimensionalen Turbo-Spin-Echo-Sequenz erfolgt die Phasenkodierung in der Regel zusätzlich in der Schichtselektionsrichtung. Beim Einsatz einer 2-dimensionalen Turbo-Spin-Echo-Sequenz wird das zu untersuchende Volumen in der Regel schichtweise erfasst. Breite, Zahl und Abstand zwischen den Einzelschichten werden in der Regel durch den Anwender vorgegeben.

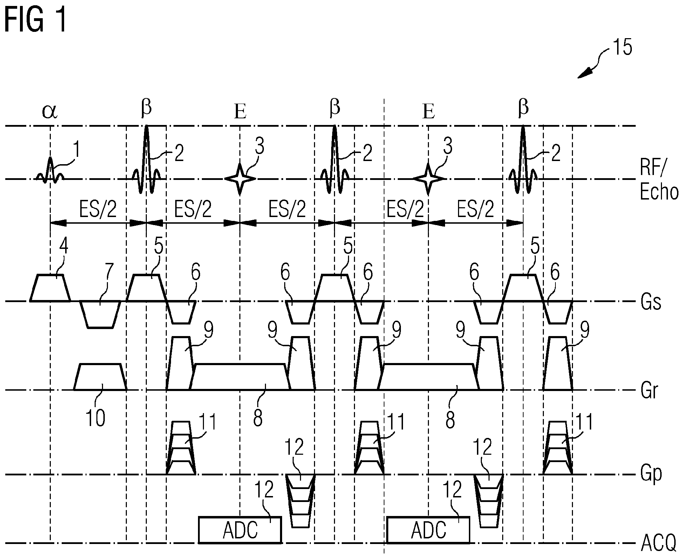

In FIG 1 ist eine herkömmliche 2D-Turbo-Spin-Echo-Pulssequenz gezeigt, mit der eine MR-Bildgebung von Rückenmark durchgeführt werden kann. Es existieren zwar andere T2-gewichtete Bildgebungsverfahren, welche robuster gegenüber Flussphänomenen sind, diese haben aber wiederum andere Nachteile und werden daher klinisch nicht oder zumindest nicht von allen Radiologen akzeptiert. Ein Beispiel für ein solches alternatives Bildgebungsverfahren ist die dreidimensionale T2-gewichtete Turbo-Spin-Echo-Pulssequenz. Bei einem solchen Bildgebungsverfahren können nichtselektive Refokussier-RF-Pulse verwendet werden, mit denen statt einer Schicht das komplette Volumen erfasst wird.

Dadurch wird bei der 3D-Bildgebung im Vergleich zur 2D-Bildgebung der Kontrast zwischen den verschiedenen Gewebekomponenten reduziert. Um mit der 3D-Technik eine Laufzeit zu erzielen, die in der Größenordnung einer entsprechend aufgelösten 2D-Messung liegt, müssen allerdings weitere Sequenzparameter im Vergleich zur 2D-Bildgebung verändert werden.

Beispielsweise muss die Echozuglänge, d.h., die Zahl der Refokussier-RF-Pulse pro Anregung erhöht werden.

Es besteht also die Aufgabe, die bei der MR-Bildgebung des Rückenmarks mit Hilfe von 2D-Spin-Echo-Pulssequenzen auftretenden Artefakte zu reduzieren, um die Bildqualität zu verbessern und damit eine Diagnose anhand der Bildaufnahme zu erleichtern.

Diese Aufgabe wird durch ein Verfahren gemäß Patentanspruch 1, durch eine Ansteuersequenz gemäß Patentanspruch 12 und durch ein Magnetresonanzbildgebungssystem gemäß Patentanspruch 13 gelöst.

Das erfindungsgemäße Verfahren zur Ansteuerung eines Magnetresonanzbildgebungssystems zur Erzeugung von Magnetresonanzbilddaten eines Untersuchungsobjekts, bei dem Magnetresonanzrohdaten erfasst werden, umfasst das Ausspielen mindestens einer Spin-Echo-Pulssequenz oder einer Turbo-Spin-Echo-Pulssequenz. Das Verfahren weist in diesem Zusammenhang einen Anregungsvorgang auf. Bei dem Anregungsvorgang wird ein RF-Anregungspuls eingestrahlt, mit dem ein Bereich, der einen abzubildenden Bereich umfasst, angeregt wird, und der angeregte Bereich wird durch mindestens einen ersten Selektionsgradienten definiert. Teil des Verfahrens ist auch ein Refokussierungsvorgang, bei dem ein RF-Refokussierungspuls eingestrahlt wird, mit dem ein Refokussierbereich beeinflusst wird. Der zu refokussierende Bereich wird dabei mit mindestens einem zweiten Selektionsgradienten definiert. Der Refokussierbereich umfasst wiederum den abzubildenden Bereich. Wird zur Definition des auszulesenden Bereichs eine eindimensionale Selektion durchgeführt, so spricht man von Schichtselektionsgradienten zur Festlegung der Breite der Schicht. Es sind aber auch Varianten mit einer zweidimensionalen Selektion möglich, bei denen dann Selektionsgradienten z.B. in zwei Raumrichtungen geschaltet werden, während RF-Pulse eingestrahlt werden.

Im Rahmen des Anregungsvorgangs und des Refokussierungsvorgangs wird die räumliche Ausdehnung des Anregungsbereichs signifikant verschieden von der räumlichen Ausdehnung des Refokussierbereichs gewählt. "Signifikant verschieden" soll in diesem Zusammenhang bedeuten, dass das Verhältnis der Ausdehnung des größeren Bereichs und des kleineren Bereichs deutlich mehr als den Wert 1,2, vorzugsweise mehr als 1,5 beträgt.

Der Wert 1,2 ist nicht mit der bei der Verwendung von identischen SINC-Pulsen für die Anregung und Refokussierung herkömmlich genutzten Absenkung der Amplitude des Schichtselektionsgradienten des Refokussier-RF-Pulses gegenüber der Amplitude des Schichtselektionsgradienten des RF-Anregungspulses zu verwechseln. Die Absenkung der Amplitude hängt damit zusammen, dass bereits herkömmlich bei der Verwendung von identischen SINC-Pulsen für die Anregung und Refokussierung das Schichtprofil des Refokussier-RF-Pulses in Folge des höheren Flip-Winkels verengt gegenüber dem Schichtprofil des Anregungspulses ist. Um dies zu kompensieren, senkt man herkömmlich die Amplitude des Schichtselektionsgradienten des Refokussier-RF-Pulses gegenüber der Amplitude des Schichtselektionsgradienten des Anregungs-RF-Pulses ab, beispielsweise um den Faktor 1,2.

Weiterhin umfasst das Verfahren einen Auslesevorgang zur Akquisition von Magnetresonanzrohdaten. Der Auslesevorgang umfasst insbesondere das Empfangen von HF-Signalen, welche durch die vorbeschriebenen Prozesse ausgelöst wurden.

Die erfindungsgemäße Ansteuersequenz zur Ansteuerung eines Magnetresonanzbildgebungssystems weist einen RF-Anregungspuls auf, mit dem ein Bereich angeregt wird, der einen abzubildendenden Bereich umfasst. Weiterhin umfasst die Ansteuersequenz mindestens einen Selektionsgradienten, durch den die Breite des angeregten Bereichs definiert wird. Unter einem Selektionsgradienten wird hier ein Gradient verstanden, der während des Einstrahlens des RF-Pulses geschaltet wird. Der angeregte Bereich kann insbesondere eine abzubildende Schicht umfassen. In diesem Fall handelt es sich bei dem die abzubildende Schicht definierenden Selektionsgradienten um einen Schichtselektionsgradienten. Teil der Ansteuersequenz ist auch ein RF-Refokussierungspuls, mit dem ein Refokussierbereich beeinflusst wird. Auch der Refokussierbereich wird mit einem Selektionsgradienten definiert und umfasst ebenfalls den abzubildenden Bereich.

Der Refokussierbereich kann insbesondere eine zu refokussierende Schicht umfassen. In diesem Fall handelt es sich bei dem die Refokussierschicht definierenden Selektionsgradienten um einen Schichtselektionsgradienten.

Die genannten RF-Pulse und Selektionsgradienten werden derart aufeinander abgestimmt, dass die räumliche Ausdehnung des Anregungsbereichs in Selektionsrichtung signifikant verschieden von der räumlichen Ausdehnung des Refokussierbereichs in Selektionsrichtung ist. Wie bereits erwähnt, soll darunter verstanden werden, dass das Verhältnis der Ausdehnung des größeren Bereichs und des kleineren Bereichs deutlich mehr als den Wert 1,2 vorzugsweise mehr als 1,5 beträgt. Schließlich umfasst die Ansteuersequenz auch ein Auslesemodul zur Akquisition von Magnetresonanzrohdaten. Die erfindungsgemäße Ansteuersequenz teilt die Vorteile des erfindungsgemäßen Verfahrens.

Das erfindungsgemäße Magnetresonanzbildgebungssystem umfasst eine Steuereinrichtung, welche zur Steuerung des Magnetresonanzbildgebungssystems unter Nutzung des erfindungsgemäßen Verfahrens ausgebildet ist. Das erfindungsgemäße Magnetresonanzbildgebungssystem teilt die Vorteile des erfindungsgemäßen Verfahrens.

Die wesentlichen Komponenten der erfindungsgemäßen Steuereinrichtung können zum überwiegenden Teil in Form von Softwarekomponenten ausgebildet sein. Grundsätzlich können diese Komponenten aber auch zum Teil, insbesondere wenn es um besonders schnelle Berechnungen geht, in Form von softwareunterstützter Hardware, beispielsweise FPGAs oder dergleichen, realisiert sein. Ebenso können die benötigten Schnittstellen zwischen einzelnen Funktionskomponenten, beispielsweise wenn es nur um eine Übernahme von Daten aus anderen Softwarekomponenten geht, als Softwareschnittstellen ausgebildet sein. Sie können aber auch als hardwaremäßig aufgebaute Schnittstellen ausgebildet sein, die durch geeignete Software angesteuert werden.

Eine weitgehend softwaremäßige Realisierung hat den Vorteil, dass auch schon bisher verwendete Steuereinrichtungen oder Ansteuersequenz-Ermittlungseinrichtungen auf einfache Weise durch ein Software-Update nachgerüstet werden können, um auf die erfindungsgemäße Weise zu arbeiten. Insofern wird die Aufgabe auch durch ein entsprechendes Computerprogrammprodukt mit einem Computerprogramm gelöst, welches direkt in eine Speichereinrichtung einer Steuereinrichtung eines Magnetresonanzbildgebungssystems ladbar ist, mit Programmabschnitten, um alle Schritte des erfindungsgemäßen Verfahrens auszuführen, wenn das Programm in der Steuereinrichtung ausgeführt wird. Ein solches Computerprogrammprodukt kann neben dem Computerprogramm gegebenenfalls zusätzliche Bestandteile wie zum Beispiel eine Dokumentation und/oder zusätzliche Komponenten auch Hardware-Komponenten, wie zum Beispiel Hardware-Schlüssel (Dongles etc.) zur Nutzung der Software, umfassen.

Zum Transport zur Steuereinrichtung des Magnetresonanzbildgebungssystems und/oder zur Speicherung an oder in der Steuereinrichtung kann ein computerlesbares Medium, beispielsweise ein Memorystick, eine Festplatte oder ein sonstiger transportabler oder fest eingebauter Datenträger dienen, auf welchem die von einer Rechnereinheit der Steuereinrichtung einlesbaren und ausführbaren Programmabschnitte des Computerprogramms gespeichert sind. Die Rechnereinheit kann z.B. hierzu einen oder mehrere zusammenarbeitende Mikroprozessoren oder dergleichen aufweisen.

Eine weitgehend softwaremäßige Realisierung hat den Vorteil, dass auch schon bisher verwendete Steuereinrichtungen von Magnetresonanzsystemen auf einfache Weise durch ein Software-Update nachgerüstet werden können, um auf die erfindungsgemäße Weise zu arbeiten. Insofern wird die Aufgabe auch durch ein Computerprogramm gelöst, welches direkt in eine Speichereinrichtung eines Magnetresonanzsystems ladbar ist, mit Programmabschnitten, um alle Schritte des erfindungsgemäßen Verfahrens auszuführen, wenn das Programm in dem Magnetresonanzsystem ausgeführt wird.

Die abhängigen Ansprüche sowie die nachfolgende Beschreibung enthalten jeweils besonders vorteilhafte Ausgestaltungen und Weiterbildungen der Erfindung. Dabei können insbesondere die Ansprüche einer Anspruchskategorie auch analog zu den abhängigen Ansprüchen einer anderen Anspruchskategorie weitergebildet sein. Zudem können im Rahmen der Erfindung die verschiedenen Merkmale unterschiedlicher Ausführungsbeispiele und Ansprüche auch zu neuen Ausführungsbeispielen kombiniert werden.

In einer Ausgestaltung des erfindungsgemäßen Verfahrens wird die Ausdehnung des Refokussierbereichs in Selektionsrichtung größer gewählt als die Ausdehnung des Anregungsbereichs. Bei dieser vorteilhaften Variante wird also ein größerer, den Anregungsbereich einschließender Refokussierbereich gewählt. Vorteilhaft werden bei dieser Ausgestaltung auch Spins erfasst, deren Träger den Anregungsbereich nach der Anregung also zeitlich zwischen Anregung und Refokussierung bzw. zwischen einer ersten und weiteren Refokussierungen bereits verlassen haben, aber sich noch in dem weiter ausgedehnten Refokussierbereich befinden. Auch diese liefern nun einen Signalbeitrag, was zu einer Verbesserung der Bildqualität beiträgt. Diese Variante eignet sich besonders gut für die Anwendung auf eine Turbo-Spin-Echo-Sequenz. Bei einer Turbo-Spin-Echo-Sequenz wird eine Refokussierung mehrfach wiederholt. Wird der Refokussierbereich ausreichend groß dimensioniert, so befinden sich die angeregten Spins der CSF auch nach mehreren Echos immer noch im Refokussierbereich. Dadurch wird eine Artefaktbildung wirksam kompensiert.

Unter einer Spin-Echo-Sequenz wird hier eine Sequenz verstanden, bei der nach jedem Anregungspuls ein Refokussier-RF-Puls geschaltet wird, um je ein Spin-Echo zu formieren. Verschiedene k-Raum-Zeilen werden also nach verschiedenen Anregungen akquiriert. In einer alternativen Ausgestaltung des erfindungsgemäßen Verfahrens wird für den Fall einer Spin-Echo-Sequenz die Ausdehnung des Anregungsbereichs größer gewählt als die Ausdehnung des Refokussierbereichs. Dabei wird angenommen, dass der Anregungsbereich den Refokussierbereich räumlich einschließt. Des Weiteren wird die Breite des Refokussierbereichs durch die von dem Anwender gewünschte Schichtdicke bestimmt. Bei dieser Ausgestaltung werden vorsorglich mehr Spins als nötig angeregt. Zwar verlassen nach der Anregung einige CSF-Spins den späteren Refokussierbereich, sie werden aber durch angeregte Spins ersetzt, die sich zum Zeitpunkt der Anregung noch außerhalb des späteren Refokussierbereichs befinden, aber während der Zeit zwischen Anregung und Refokussierung in den Refokussierbereich einfließen. Auf diese Weise wird das Bildsignal im Vergleich zu einem Szenario, bei dem der Anregungsbereich und der Refokussierbereich gleich dimensioniert sind, verbessert.

In einer schichtselektiven Variante des erfindungsgemäßen Verfahrens umfasst der abzubildende Bereich eine Anregungsschicht, welche durch einen Schichtselektionsgradienten definiert wird, und umfasst der Refokussierbereich eine Refokussierschicht, welche durch einen Schichtselektionsgradienten definiert wird. Dabei wird die räumliche Schichtdicke der Anregungsschicht signifikant verschieden von der Schichtdicke der Refokussierschicht gewählt.

Bei der schichtselektiven Variante kann die Refokussierschicht dicker als die Anregungsschicht gewählt werden. Dabei umfasst die Refokussierschicht die Anregungsschicht zumindest teilweise, vorzugsweise vollständig. Besonders vorteilhaft ist die erfinderische Methode, wenn die Bewegungsrichtung der CSF-Spins im Wesentlichen mit der Schichtselektionsrichtung übereinstimmt, also im Wesentlichen senkrecht zur Schichtebene erfolgt. In diesem Fall werden durch die Verbreiterung der Refokussierschicht im Vergleich zu der Anregungsschicht bei der Bildgebung auch CSF-Spins erfasst, die die Anregungsschicht nach der Anregung verlassen, sich aber während einer Refokussierung noch in der Refokussierschicht aufhalten. Eine solche Vorgehensweise eignet sich besonders für die 2D-Turbo-Spin-Echo-Sequenz.

Für den speziellen Fall einer 2D-Spin-Echo-Sequenz kann alternativ auch die Anregungsschicht dicker als die Refokussierschicht gewählt werden. Dabei ist es wiederum vorteilhaft, wenn sich die CSF-Spins in Richtung der Schichtdicke bewegen. Schließt die dickere Anregungsschicht die Refokussierschicht ein, so bewegen sich CSF-Spins, die sich während der Anregung noch nicht in der späteren Refokussierschicht aufgehalten haben, während der Zeit zwischen Anregung und Refokussierung in die Refokussierschicht hinein und ersetzen angeregte CSF-Spins, die die Refokussierschicht in dieser Zwischenzeit verlassen haben. Nur Spins, die von beiden RF-Pulsen erfasst wurden, tragen zum Signal bei. Auf diese Weise wird also der "time of flight loss"-Effekt ebenfalls kompensiert.

In einer bevorzugten Variante des erfindungsgemäßen Verfahrens ist die Dicke der dünneren der beiden Schichten gleich einer vom Anwender vorgegebenen Schichtdicke. Bei dieser Variante wird die Dicke der dünneren der beiden Schichten entsprechend der gewünschten Auflösung in Schichtselektionsrichtung gewählt. Vorteilhaft verschlechtert sich die Auflösung von statischen Gewebekomponenten hierbei nicht. Verbreitert man dagegen Anregungs-und Refokussierschicht, wie es in der Literatur zur Verringerung des "time of flight loss"-Effekts vorgeschlagen wird, dann verschlechtert sich mit zunehmender Schichtdicke auch die Auflösung von statischem Gewebe in Schichtselektionsrichtung.

Besonders vorteilhaft ist es, wenn bei dem erfindungsgemäßen Verfahren der Pulsparameter des Anregungspulses bzw. des Refokussier-RF-Pulses derart gewählt werden, dass die Schichtselektionsgradienten beider RF-Pulse annähernd die gleiche Amplitude haben. Dadurch wird erreicht, dass im Falle einer lokalen Off-Resonanz Anregungs-und Refokussierschicht gleich gekrümmt werden und somit verhindert, dass es aufgrund eines mangelnden Überlappens von angeregter und refokussierter Schicht zu einem teilweise oder gar totalen Signalverlust kommt. Unter einer lokalen Off-Resonanz wird hier eine lokale Abweichung vom idealerweise konstanten $B_0$-Feld verstanden, z.B. in Folge von Suszeptibilität-Effekten.

In einer besonders effektiven Variante des erfindungsgemäßen Verfahrens werden die Pulsparameter des breiteren RF-Pulses derart angepasst, dass die Schichtselektionsgradienten beider RF-Pulse annähernd die gleiche Amplitude haben.

In einer alternativen Ausgestaltung des erfindungsgemäßen Verfahrens wird ein Gradienten-Schema in Schichtselektionsrichtung gewählt, dessen erstes Moment in der zeitlichen Mitte der Refokussier-RF-Pulse den Wert Null aufweist.

Unter dem n-ten Moment $m_n(t)$ einer Gradientenanordnung $G_i$ versteht man das Integral

$$m_n(t) = \int_0^t G_i(\tau) \cdot \tau^n d\tau \ . \qquad (1)$$

Damit erhält man für die Phase einer kleinen Probe, die sich zum Zeitpunkt 0 (Mitte des Anregungspulses) am Ort $r_0$ befindet und sich mit konstanter Geschwindigkeit $v_0$ durch das Messvolumen bewegt:

$$\phi(t) = 2\pi\gamma \int_0^t \vec{G}(\tau)\vec{r}(\tau)d\tau = 2\pi\gamma \int_0^t \vec{G}(\tau)[\vec{r}_0 + \vec{v}_o(\tau)]d\tau = 2\pi\gamma[\vec{m}_0\vec{r}_0 + \vec{m}_1\vec{v}_0] \qquad (2)$$

Bewegte Spins akquirieren also eine zusätzliche Phase φ die proportional zu ihrer Geschwindigkeit $v_0$ und zum ersten Moment der Gradientenanordnung G ist.

Das Signal in der Turbo-Spin-Echo-Bildgebung ist ab dem zweiten Echo eine Überlagerung von verschiedenen Signalkomponenten, die von Spins ausgehen, die unterschiedlichen Signalpfaden folgen. Falls ein fließender Spin einem Signalpfad folgt, der stimulierte Echos enthält, dann wird seine Magnetisierung während einiger Echoabstände in der longitudinalen Richtung gespeichert. Während dieser Zeit wird er nicht von den geschalteten Gradienten beeinflusst und akquiriert damit auch keine extra Phase in Folge der Bewegung. Voraussetzung dafür, dass sich das Signal von fließenden Spins, die unterschiedlichen Echopfaden folgen, konstruktiv addiert, ist, dass die Nettophase, die innerhalb eines Echoabstands akquiriert wird (bzw. die Nettophase, die zwischen zwei Refokussier-RF-Pulsen akquiriert wird) Null ist. Dies wird durch ein Gradienten-Schema erreicht, dessen 1. Moment in der Mitte der Refokussier-RF-Pulse Null ist.

In einer Ausführungsform des erfindungsgemäßen Verfahrens wird ein Gradienten-Schema gewählt, dessen erstes Moment zum Zeitpunkt der Refokussier-RF-Pulse Null ist. Damit wird erreicht, dass keine Phase in Folge der Bewegung zwischen zwei beliebigen Refokussier-RF-Pulsen akquiriert wird. Dies ist, wie eben ausführlich dargelegt, eine notwendige Voraussetzung, damit Echopfade, die eine unterschiedliche Anzahl von stimulierten Echos und Spin-Echos enthalten, kohärent überlagern.

Ist die Geschwindigkeit der verschiedenen Spins, die zu dem Signal eines Voxels und damit eines Bildpunktes (Pixel) beitragen, unterschiedlich, so kann die zusätzliche Phase φ, die in Folge der Bewegung zwischen Refokussier-RF-Puls und Echo akquiriert wird, zu einer Dephasierung des Signals und damit zu Auslöschungen in den berechneten Bildern führen.

In einer weiteren Ausführungsform des erfindungsgemäßen Verfahrens wird deshalb ein Gradienten-Schema in Schichtselektionsrichtung gewählt, dessen erstes Gradientenmoment zusätzlich zum Zeitpunkt der Echos (also während des Ausleseintervalls) den Wert Null aufweist. Damit wird die beschriebene Dephasierung des Signals reduziert und damit einer Signalreduktion bzw. Signalauslöschung entgegengewirkt.

In einer besonders effektiven Ausgestaltung des erfindungsgemäßen Verfahrens wird bei der Akquisition der einzelnen Schichten ein verschachteltes Akquisitionsschema angewendet. Diese Anwendung erfolgt, um ein Übersprechen bzw. Überlappen von einzelnen Schichten zu vermeiden. Bei einem solchen verschachtelten Akquisitionsschema werden die zu akquirierenden Schichten in Sub-Sätze eingeteilt. Die Sub-Sätze werden dann nacheinander akquiriert. Beispielsweise umfasst ein erster Sub-Satz nur die geradzahligen Schichten und ein zweiter Sub-Satz nur die ungeradzahligen Schichten. Die Nummerierung der einzelnen Schichten entspricht dabei ihrer anatomischen Position. Anders ausgedrückt, wird die Schichtnummer von einer Schicht zu ihrer direkt räumlich benachbarten Schicht um den Wert 1 inkrementiert bzw. dekrementiert. Mithin wird durch die Einteilung in Sub-Sätze der Abstand zwischen nacheinander anzuregenden und auszulesenden Schichten erhöht, wodurch ein Übersprechen bzw. Überlappen von nacheinander auszulesenden Schichten insbesondere in Folge der erfindungsgemäßen verbreiterten Refokussier-bzw. Anregungsschicht vermieden werden kann. Auch Einteilungen in mehr als zwei Sub-Sätze sind möglich, um den effektiven Schichtabstand weiter zu vergrößern und damit die Gefahr eines Überlappens direkt nacheinander ausgelesener Schichten bzw. eines Übersprechens und damit verbundener Bildartefakte zu verhindern. Ein typischer Wert bei der Anwendung des erfindungsgemäßen Verfahrens in der Bildgebung mit Turbo-Spin-Echo-Sequenzen ist die Verbreiterung des Refokussierbereiches gegenüber der vom Anwender vorgegebenen Schichtdicke d um einen Faktor 3. Sofern der Schichtabstand des Schichtpaketes klein gegenüber der vorgegeben Schichtdicke d ist, sollte der Schichtstapel dann in mindestens 4 Subdatensätze gemessen werden, um das Übersprechen zu vermeiden.

Die Erfindung wird im Folgenden unter Hinweis auf die beigefügten Figuren anhand von Ausführungsbeispielen noch einmal näher erläutert. Es zeigen:

FIG 1 ein Sequenzdiagramm, welches eine herkömmliche flusskompensierte 2D-Turbo-Spin-Echo-Sequenz darstellt,

FIG 2 ein Sequenzdiagramm, in dem der "Time-of-Flight-Loss"-Effekt veranschaulicht wird,

FIG 3 ein Sequenzdiagramm, in dem eine Pulssequenz für ein MR-Bildgebungsverfahren gemäß einem ersten Ausführungsbeispiel der Erfindung veranschaulicht wird,

FIG 4 ein Sequenzdiagramm, in dem eine Pulssequenz für ein MR-Bildgebungsverfahren gemäß einem zweiten Ausführungsbeispiel der Erfindung veranschaulicht wird,

FIG 5 ein Schaubild einer Sinc-Funktion eines RF-Pulses,

FIG 6 eine Simulation einer flusskompensierten Turbo-Spin-Echo-Pulssequenz mit einem Verbreiterungsfaktor des Refokussier-Pulses von 3 durch einen abnehmenden Schichtselektionsgradienten,

FIG 7 eine Simulation einer flusskompensierten Turbo-Spin-Echo-Pulssequenz mit einem Verbreiterungsfaktor des Refokussier-Pulses von 3 durch ein zunehmendes Bandbreite-Zeit-Produkt,

FIG 8 ein Flussdiagramm, welches ein Verfahren zur Ansteuerung eines Magnetresonanzbildgebungssystems zur Erzeugung von Magnetresonanzbilddaten eines Untersuchungsobjekts, bei dem Magnetresonanzrohdaten erfasst werden, veranschaulicht,

FIG 9 ein Magnetresonanzbildgebungssystem gemäß einem Ausführungsbeispiel der Erfindung.

In FIG 1 ist in einem Sequenzdiagramm 15 eine herkömmliche flusskompensierte 2D-Turbo-Spin-Echo-Pulssequenz gezeigt. Das Sequenzdiagramm 15 umfasst insgesamt fünf Zeilen, wobei die erste Zeile mit RF/Echo bezeichnet ist und die gemäß der 2D-Turbo-Spin-Echo-Pulssequenz eingestrahlten sogenannten RF-Pulse 1, 2, sowie deren Echos 3 wiedergibt. Oberhalb des ersten RF-Pulses 1 ist der griechische Buchstabe $\alpha$ eingezeichnet. Der Buchstabe $\alpha$ soll symbolisieren, dass es sich bei dem ersten RF-Puls 1 um einen sogenannten Anregungspuls handelt. Über dem zweiten RF-Puls 2 ist der griechische Buchstabe $\beta$ eingezeichnet, welcher symbolisieren soll, dass es sich bei dem zweiten Puls um einen sogenannten Refokussierungspuls handelt. Über den Echos 3 ist der lateinische Buchstabe E dargestellt, welcher symbolisieren soll, dass es sich bei diesen um Echos handelt. In der zweiten Zeile, welche mit Gs bezeichnet ist, sind Gradienten 4, 5, 6, 7 in Schichtselektionsrichtung gezeigt. In der dritten Zeile, welche mit Gr bezeichnet ist, sind Gradienten 8, 9, 10, die in Ausleserichtung geschaltet werden, veranschaulicht. In der vierten Zeile, welche mit Gp bezeichnet ist, sind Gradienten 11, 12, die in Phasenkodierrichtung geschaltet werden, dargestellt. In der fünften Zeile, welche mit ACQ gekennzeichnet ist, sind Auslesefenster ADC dargestellt, also die Zeitfenster 12, in denen Messdaten akquiriert werden.

Eine solche 2D-Turbo-Spin-Echo-Sequenz umfasst einen 90°-Anregungspuls 1, der initial die Magnetisierung in einer Schicht im Untersuchungsbereich in die transversale Ebene kippt. Auf den Anregungspuls 1 folgt in einem zeitlichen Abstand einer halben Echozeit ES/2 ein erster Refokussier-RF-Puls 2. Die Echozeit ES, auch als Echoabstand bezeichnet, ist eine charakteristische Zeitkonstante der Sequenz. Sie gibt die Zeit zwischen den einzelnen Echosignalen 3 an. Auf den ersten Refokussier-RF-Puls 2 folgen im Rahmen der Turbo-Spin-Echo-Sequenz noch weitere Refokussier-RF-Pulse 2 mit einem jeweiligen zeitlichen Abstand ES zueinander. Außerdem wird in der zweidimensionalen Bildgebung synchron mit dem Anregungspuls 1 und dem Refokussier-RF-Puls 2 ein Gradient 4, 5 geschaltet, dessen Amplitude derart an die jeweilige spektrale Bandbreite des RF-Pulses 1, 2 angepasst ist, dass senkrecht zu dem Gradienten eine eindimensional begrenzte Schicht einer gewünschten Dicke d angeregt bzw. refokussiert wird. Unter der Dicke d versteht man in der Regel die Breite des Anregungsprofils bis zu der Stelle, bei der das Anregungssignal nur noch die Hälfte seiner Maximalamplitude aufweist. Die jeweils angeregte und refokussierte Schicht kann in Richtung des Schichtselektionsgradienten 4, 5 durch eine geeignete Wahl der RF-Mittenfrequenz, auch als Trägerfrequenz bezeichnet, verschoben werden. Zum Auslesen wird in der zeitlichen Mitte zwischen zwei aufeinanderfolgenden Refokussier-RF-Pulsen 2 ein Echosignal 3 erfasst. Dieses Echosignal 3 wird in der Regel mit einem Auslesegradienten 8 frequenzkodiert und es wird dem Echosignal 3 mit Hilfe eines Phasenkodiergradienten 11 eine Phase aufgeprägt. Die aufgeprägte Phase wird dabei derart zwischen den einzelnen Echosignalen geändert, dass aus allen ausgelesenen Echos 3 ein MR-Bild der Schicht berechnet werden kann. Der Auslesegradient 8 und der Phasenkodiergradient 11 werden dabei orthogonal zueinander und orthogonal zum Schichtselektionsgradienten 4, 5 geschaltet. Anschließend wird ein Phase-Rephasiergradient 12 ausgespielt, um die Phase zwischen dem Ausleseintervall und dem nächsten Refokussier-RF-Puls 5 wieder zurückzudrehen. Mit Hilfe eines Paars sogenannter Crusher-Gradienten 9, die unmittelbar vor und nach den Refokussier-RF-Pulsen 2 geschaltet werden, wird verhindert, dass von dem Refokussier-RF-Puls 2 neu in die transversale Ebene gekippte Spins einen Signalbeitrag liefern. Der Grund für den Time-of-Flight-Verlust besteht darin, dass fließendes bzw. pulsierendes CSF, das sich zur Zeit der Anregung in der jeweils angeregten und später refokussierten Schicht befunden hat, in der Zeit zwischen Anregung und Refokussierung diese Schicht verlässt, und damit nicht refokussiert wird und demzufolge in den nachfolgend generierten Echos auch keinen Signalbeitrag liefert. Frisches in die Schicht einfließendes CSF wurde nicht von dem Anregungspuls erfasst und liefert daher auch keinen Signalbeitrag.

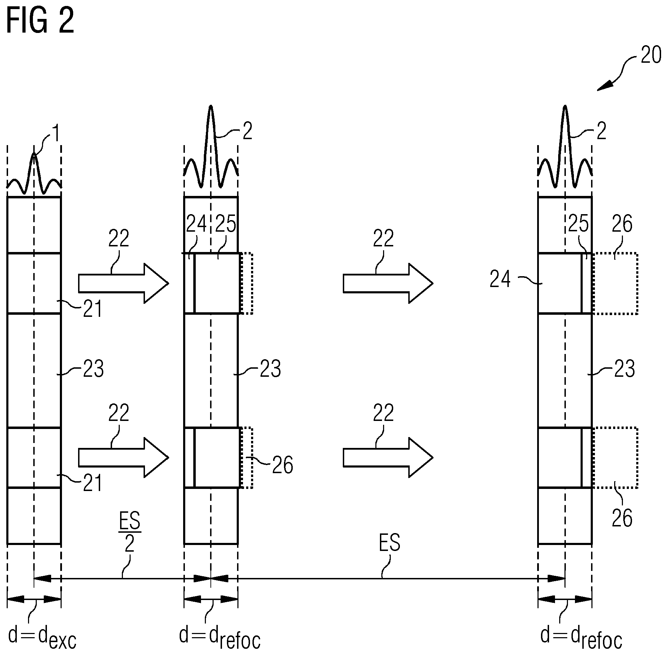

In FIG 2 wird ein Sequenzdiagramm 20 mit einer Pulssequenz gezeigt, deren Anwendung zu Bildartefakten basierend auf dem sogenannten "Time-of-Flight-Loss"-Effekt führt. Links in FIG 2 ist eine Schicht der Dicke d zum Zeitpunkt der Schichtanregung gezeigt. In der vereinfachten Darstellung werden sowohl statische Spins 23 des Rückenmarks wie auch dynamische CSF-Spins 21, die sich zum Zeitpunkt der Anregung in der Schicht der Dicke d befinden, angeregt, also in die transversale Ebene gekippt. Die waagrechten Pfeile 22 in FIG 2 sollen den Fluss der Cerebrospinalflüssigkeit zwischen Anregung und Refokussierung bzw. zwischen den beiden Refokussierungen darstellen. In der Mitte von FIG 2 ist dieselbe Schicht zu einem einen halben Echoabstand ES/2 späteren Zeitpunkt des ersten Refokussier-RF-Pulses gezeigt. Dabei ist bei der abgebildeten Sequenz im Stand der Technik die nominelle Dicke der Schicht $d_{refoc}$, die von dem Refokussier-RF-Puls erfasst wird, gleich der Dicke der Anregungsschicht $d_{exc}$ gewählt ($d_{exc} = d_{refoc} = d$). Die statischen Spins 23 des Rückenmarks, die sich zum Zeitpunkt der Anregung in der betrachteten Schicht befunden haben, befinden sich weiterhin in der erfassten Schicht und werden komplett refokussiert, so dass sie zum ersten und den weiteren formatierten Echos einen Signalbeitrag liefern. Ein Teil 26 der fließenden CSF-Spins, die sich zum Zeitpunkt der Anregung in der betrachteten Schicht befunden haben, verlässt in der Zeit zwischen Anregung und Refokussierung die Schicht wieder. Dieser Teil wird vom Refokussier-RF-Puls nicht erfasst und liefert in den später refokussierten Echos somit keinen Signalbeitrag. Die ausfließenden CSF-Spins 24 werden durch CSF-Spins 24 ersetzt, die sich zum Zeitpunkt der Anregung nicht in der betrachteten Schicht befunden haben und wegen der fehlenden Anregung auch keinen Signalbeitrag liefern. Auf der rechten Seite in FIG 2 ist dieselbe Schicht zum Zeitpunkt des zweiten Refokussier-RF-Pulses 2 dargestellt, d.h. ein Zeitintervall ES nach dem ersten Refokussier-RF-Puls 2. Mit anwachsender Zeit zwischen Anregung und Refokussierung erhöht sich der Anteil der CSF-Spins 26, die die Schicht verlassen, und erniedrigt sich der Anteil 25 der CSF-Spins, die zu den fokussierten Echos einen Signalbeitrag leisten.

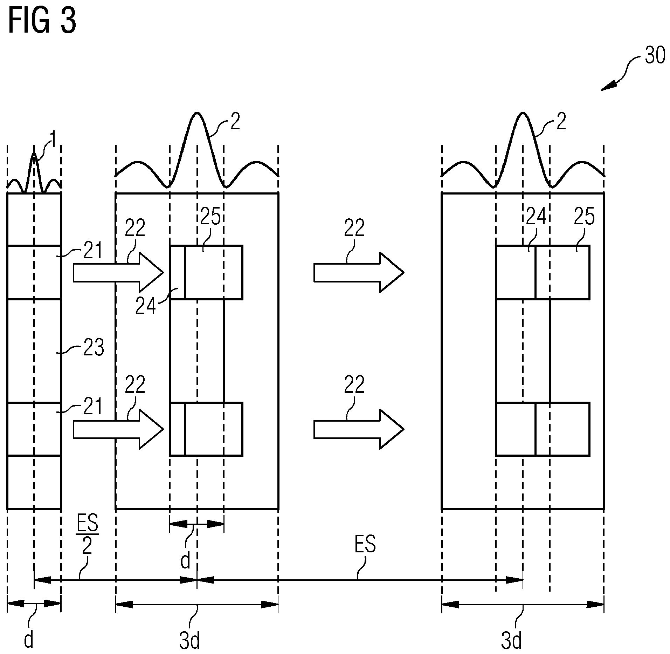

In FIG 3 ist eine Pulssequenz 30 für ein MR-Bildgebungsverfahren gemäß einem ersten Ausführungsbeispiel der Erfindung veranschaulicht. Die in FIG 3 veranschaulichte Pulssequenz ermöglicht die Vermeidung bzw. Reduktion der auf den "Time-of-Flight-Loss"-Effekt zurückzuführenden Bildartefakte. Links in FIG 3 ist wiederum eine Schicht der Dicke d zum Zeitpunkt der Schichtanregung gezeichnet. In dieser Ausführungsform der Erfindung ist die Anregung unverändert gegenüber dem Stand der Technik. Demzufolge werden in der vereinfachten Darstellung also wieder sowohl statische Spins 23 des Rückenmarks wie auch dynamische CSF-Spins 21, die sich zum Zeitpunkt der Anregung in der Schicht der Dicke d befinden, angeregt, also in die transversale Ebene gekippt. Spins au-ßerhalb der Schicht werden nicht angeregt. Die Dicke d der Schicht ist dabei vom Anwender in der Regel vorgegeben und bestimmt die Auflösung in Schichtselektionsrichtung.

In der Mitte von FIG 3 ist dieselbe Schicht zu dem einen halben Echoabstand ES/2 späteren Zeitpunkt des ersten Refokussier-RF-Pulses 2 gezeigt. Dabei ist bei dieser Ausführungsform die nominelle Dicke der Schicht, die von dem Refokussier-RF-Puls 2 erfasst wird, gegenüber der Dicke d der Anregungsschicht, die von dem Anregungspuls 1 erzeugt wird, um einen Faktor 3 erhöht. Mit den inneren vertikalen gestrichelt gezeichneten Linien ist der Bereich der Refokussier-Schicht abgegrenzt, der vom Anregungspuls erfasst wurde. Dieser Bereich wird im Folgenden "innere Schicht" oder "innere Schicht der Dicke d" genannt. Die statischen Spins 23 des Rückenmarks in diesem Bereich werden von dem Anregungspuls 1 und dem Refokussier-RF-Puls 2 erfasst, so dass sie zu den später fokussierten Echos einen Signalbeitrag liefern. Rückenmark-Spins außerhalb dieses Bereichs liefern weiterhin wegen der fehlenden Anregung keinen Signalbeitrag. Eine Änderung ergibt sich dagegen bei den fließenden CSF-Spins. Die CSF-Spins 25, die sich zum Zeitpunkt der Anregung in der inneren Schicht der Dicke d befunden haben und die innere Schicht zwischen Anregung und erstem Refokussier-RF-Puls 2 verlassen haben, werden trotzdem von dem verbreiterten Refokussier-RF-Puls 2 erfasst und liefern demzufolge in den später fokussierten Echos einen Signalbeitrag, sofern sie nicht so schnell fließen, dass sie auch den (im Beispiel 3d breiten) Bereich der von den Refokussier-RF-Pulsen 2 erfasst wird, verlassen. CSF-Spins 24, die sich zum Zeitpunkt der Anregung nicht in der inneren Schicht der Dicke d befunden haben, liefern weiterhin wegen der fehlenden Anregung keinen Signalbeitrag, so dass die Auflösung in Schichtselektionsrichtung unverändert ist und durch die (vom Benutzer vorgegebene) Dicke d der Anregungsschicht bestimmt wird.

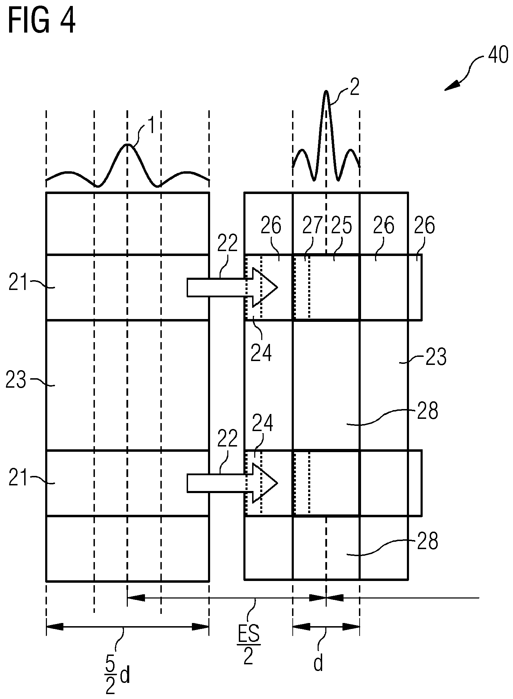

In FIG 4 wird eine Spin-Echo-Pulssequenz 40 veranschaulicht, welche Teil einer Ausführungsform des Verfahrens gemäß der Erfindung ist. Mit dieser Pulssequenz 40 kann der "Time-of-Flight-loss" vermieden bzw. signifikant reduziert werden. Bei dieser Ausführungsform wird anstatt der Refokussierschicht die Anregungsschicht um einen Faktor x gegenüber der vom Benutzer vorgegebenen gewünschten Breite d verbreitert, während die Breite der Refokussierschicht gegenüber dem Stand der Technik unverändert ist. Links in FIG 4 wird eine Schicht der Breite xxd angeregt, wobei in der Abbildung x den Wert 2,5 hat. Demzufolge werden in der vereinfachten Darstellung also sowohl statische Spins 23 des Rückenmarks wie auch dynamische CSF-Spins 21, die sich zum Zeitpunkt der Anregung in der Schicht der Dicke x×d befinden, angeregt, also in die transversale Ebene gekippt. Spins außerhalb der Schicht werden nicht angeregt. Die Dicke der Anregungsschicht ist dabei gegenüber der vom Anwender in der Regel vorgegebenen Dicke d um einen Faktor x verbreitert. Auf der rechten Seite von FIG 4 ist dieselbe Schicht zu dem einen halben Echoabstand ES/2 späteren Zeitpunkt des Refokussier-RF-Pulses 2 gezeigt. In dieser Ausführungsform der erfindungsgemäßen Sequenz 40 ist die nominelle Dicke d der Schicht, die von dem Refokussier-RF-Puls 2 erfasst wird, unverändert gegenüber dem Stand der Technik also gleich der Benutzervorgabe d. Trotzdem ist eine "äußere Schicht", deren Breite gleich der Anregungsschicht ist, also x×d (x = 5/2), zusätzlich eingezeichnet. Die statischen Spins 28 des Rückenmarks, die sich innerhalb der inneren Schicht der Breite d befinden, werden von dem Anregungspuls 1 und dem Refokussier-RF-Puls 2 erfasst, so dass sie zu dem später fokussierten Echo einen Signalbeitrag liefern. Statische Rückenmark-Spins 23, die sich außerhalb dieses Bereichs der Breite d, aber innerhalb der äußeren Schicht der Breite x×d befinden, wurden zwar angeregt, liefern wegen der fehlenden Refokussierung aber keinen Signalbeitrag. Eine Änderung gegenüber dem Stand der Technik ergibt sich wiederum bei den fließenden CSF-Spins 21. Die CSF-Spins 27, die in dem Zeitintervall zwischen Anregung und erstem Refokussier-RF-Puls 2 neu in die innere Schicht der Breite d einfließen und sich zum Zeitpunkt der Anregung in dem breiteren vom Anregungspuls 1 erfassten Bereich befunden haben, wurden angeregt und refokussiert und liefern somit in den später fokussierten Echos 3 einen Signalbeitrag. CSF-Spins 24, die sich zum Zeitpunkt der Anregung nicht in der Schicht der Dicke 2,5 d befunden haben, liefern weiterhin wegen der fehlenden Anregung keinen Signalbeitrag.

"Neue" CSF-Spins, die so schnell fließen, dass sie sich zum Zeitpunkt der Anregung außerhalb der äußeren vom Anregungspuls 1 erfassten Schicht befunden haben, liefern keinen Signalbeitrag (nicht gezeichnet). CSF-Spins 26, die sich zum Zeitpunkt der Refokussierung nicht in der inneren Schicht der Dicke d befinden, liefern wegen der fehlenden Refokussierung keinen Signalbeitrag, so dass die Auflösung in Schichtselektionsrichtung für statische und dynamische Spins durch die (vom Benutzer vorgegebene) Dicke d bestimmt wird. Die in FIG 4 gezeigte Variante funktioniert nur mit einer einfachen Refokussierung, da bei einer wiederholten Refokussierung CSF-Signal von Spins für das zweite Echo verloren geht, das in der Zeit zwischen erstem und zweiten Refokussier-RF-Puls die dünne Refokussierschicht verlässt.

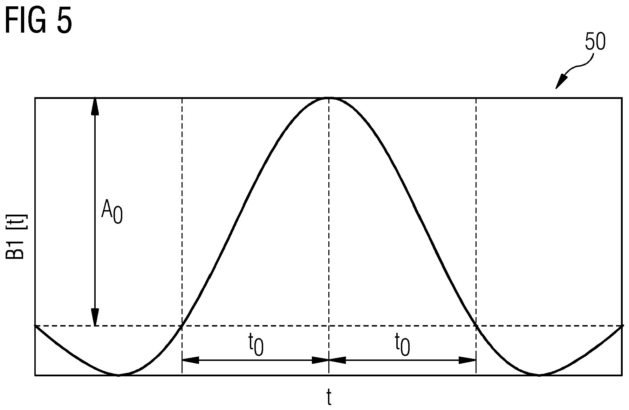

FIG 5 zeigt ein Schaubild einer einhüllenden Sinc-Funktion eines RF-Pulses.

Es sei erwähnt, dass der "Time-of-Flight-Loss" nicht der einzige physikalische Effekt ist, der zu einem Verlust von CSF-Signal führt. Eine weitere wichtige Ursache für Signalverluste kann turbulenter Fluss sein. Turbulenter Fluss führt in der Turbo-Spin-Echotechnik dazu, dass stimulierte Spins und Spin-Echos unterschiedliche Phase akquirieren und deshalb nicht mehr konstruktiv überlagern. Dies kann zu Signalverlust und sogar kompletter Signalauslöschung führen. Der Effekt lässt sich, sofern die Hauptflussrichtung wie bei der axialen Bildgebung des Rückenmarks mit der Schichtselektionsrichtung übereinstimmt, durch Nullsetzen des ersten Gradienten-Moments in Schichtselektionsrichtung in der zeitlichen Mitte der Refokussier-RF-Pulse reduzieren. Solche Gradienten-Schemata sind unter den Stichworten "Gradient Moment Nulling" oder Fluss bzw. Geschwindigkeit kompensierte Gradienten Schemata im Stand der Technik bekannt und z.B. in dem Artikel "Gradient Moment Nulling in Fast Spin Echo" von R. Scott Hink und Todd Constable, erschienen in der Zeitschrift MRM 32: Seite 698-706 (1994), beschrieben. Die in FIG 1 gezeichnete Sequenz ist in diesem Sinne flusskompensiert. Die Gradienten-Schemata, die das erste und das nullte Gradientenmoment zum Zeitpunkt der Refokussier-RF-Pulse den Wert 0 annehmen lassen, können den Effekt aber nur für gleichförmigen Fluss mit konstanter Geschwindigkeit komplett kompensieren. Der CSF-Fluss pulsiert aber mit dem Herzzyklus, verhält sich also nicht gleichförmig. Trotzdem wird eine Kombination des erfindungsgemäßen Verfahrens mit einem derart flusskompensierten Gradienten-Schema in Schichtselektionsrichtung zum Zeitpunkt der Refokussier-RF-Pulse empfohlen. Ferner sind TSE-Gradienten-Schemata bekannt, deren erstes Moment in Schichtselektionsrichtung zusätzlich zum Zeitpunkt der Echos, also während des Ausleseintervalls, den Wert 0 annehmen lassen (nicht gezeichnet).

Weiterhin ist eine Kombination derartiger Gradienten-Schemata mit der erfindungsgemäßen Verbreiterung der Anregungs- bzw. der Refokussier-RF-Pulse möglich und vorteilhaft. Gradienten-Schemata, die zu einer höheren Ordnung als der ersten kompensiert sind, können theoretisch auch komplexeren Fluss kompensieren, spielen aber praktisch wegen des erhöhten Zeitbedarfs und der damit notwendigen Verlängerung des Echoabstands keine Rolle.

Ein weiterer Effekt, der das CSF-Signal reduzieren kann und auch nicht durch das erfindungsgemäße Verfahren kompensiert wird, kann in einer Mehrschicht-Sequenz auftreten, bei der benachbarte Schichten in einem gemeinsamen TR-Intervall (die Repetitionszeit TR gibt die Zeit zwischen zwei Anregungspulsen an) angeregt wurden, wenn CSF-Spins, die in einer früheren Anregung bereits gesättigt wurden, in eine Nachbarschicht einfließen. Diese Spins liefern wegen der langen T1-Zeit von CSF in den fokussierten Echos einen reduzierten Signalbeitrag. Dieser Effekt ließe sich nur vermeiden, indem man die Schichten sukzessive akquiriert, also die Akquisition einer zweiten Schicht erst beginnt, wenn die Daten der ersten Schicht vollständig akquiriert sind, usw.. Ein solches Aufnahmeschema ist aber zeitlich in der klinischen Praxis nicht akzeptabel.

Im Zusammenhang mit der vorliegenden Erfindung ist wegen der Verbreiterung des Anregungspulses bzw. der Refokussier-RF-Pulse ein sogenanntes verschachteltes Akquisitionsschema notwendig, um das Übersprechen bzw. Überlappen der Schichten zu vermeiden. Unter einem verschachtelten Akquisitionsschema wird hier ein Akquisitionsschema verstanden, bei dem die zu akquirierenden Schichten in Sub-Sätze eingeteilt werden, die sukzessive akquiriert werden. Bei zwei Sub-Sätzen werden z.B. zuerst nur die geraden Schichten akquiriert und erst, wenn die geraden Schichten vollständig akquiriert sind, wird mit der Akquisition der ungeraden Schichten begonnen. Die Nummerierung der Schicht entspricht dabei ihrer anatomischen Position. Also wird die Schichtnummer von einer Schicht zu ihrer direkten räumlichen Nachbarschicht inkrementiert bzw. dekrementiert. Eine Einteilung in zwei Sub-Sätze verdoppelt also den effektiven Schichtabstand. Entsprechendes gilt bei der Einteilung in drei oder mehr Sub-Sätze. Verschachtelte Akquisitionsschemata sind optional auf modernen MR-Anlagen anwählbar. Bei Siemens-Scannern gibt man z.B. die Zahl der gewünschten Sub-Sätze als "Concatenations" vor. Bei Philips-Scannern heißt der entsprechende Parameter "packages". Eine Schichtselektion wird erzielt, indem ein amplitudenmodulierter RF-Puls (z.B. mit einer SINC-förmigen Einhüllenden) simultan mit einem Schichtselektionsgradienten geschaltet wird. Eine charakteristische Größe des selektiven RF-Pulses ist seine RF-Bandbreite $\Delta f$, die das Band von Frequenzen angibt, die der RF-Puls enthält.

Die Amplitude des Schichtselektionsgradienten $G_z$ wählt man abhängig von der RF-Bandbreite derart, dass eine Schicht der gewünschten Dicke d angeregt bzw. refokussiert wird:

$$d = \frac{\Delta f}{\left(\frac{\gamma}{2\pi}\right)G_z} \quad . \tag{3}$$

Dabei ist $\gamma/2\pi$ das gyromagnetische Verhältnis und beträgt für Wasserstoffprotonen 42,576 MHz/T.

Die technisch einfachste Methode, die Dicke d der Refokussierungsschicht um einen Faktor x zu erhöhen, besteht also darin, die Amplitude des Schichtselektionsgradienten $G_z$ bei ungeänderter Form und Dauer des RF-Pulses um einen Faktor x abzusenken.

Diese Vorgehensweise hat aber einen Nachteil. Die Resonanzfrequenz der MR-Anlage wird durch Einbringen des menschlichen Körpers lokal gestört. Diese Störung versucht man zwar durch Schalten von zusätzlichen Feldern (dem sogenannten patientenspezifischen Shimmen) zu kompensieren, dies gelingt aber für den in dem Zusammenhang mit der vorliegenden Erfindung besonders interessanten Bereich des menschlichen Nackens bei Weitem nicht vollständig. Vielmehr kann die Resonanzfrequenz im Untersuchungsbereich primär in Fuß-Kopf-Richtung und insbesondere bei höheren Feldstärken um einige Hundert Herz variieren.

Den Ort der Schichtanregung senkrecht zum Schichtselektionsgradienten legt man durch eine geeignete Wahl der Trägerfrequenz $f_{RF}$ des RF-Pulses fest:

$$f_{RF} = \frac{\gamma}{2\pi}\left(B_0 + \overrightarrow{G_z}\cdot\vec{r}\right) = f_0 + \frac{\gamma}{2\pi}\cdot\overrightarrow{G_z}\cdot\vec{r}. \qquad (4)$$

Dabei ist $\overrightarrow{G_z}$ der Schichtselektionsgradient, $\vec{r}$ ein Vektor, der von dem Isocenter der MR-Anlage auf den gewünschten Ort der Schichtanregung zeigt und "·" ist das Skalarprodukt der beiden Vektoren. Damit hängt die Trägerfrequenz $f_{RF}$ vom gewünschten Abstand $z_0$ der Schicht vom Isocenter in Richtung des Schichtselektionsgradienten ab

$$z_0 = \frac{\overrightarrow{G_z}\cdot\vec{r}}{|\overrightarrow{G_z}|} = \frac{\overrightarrow{G_z}\cdot\vec{r}}{G_z}. \qquad (5)$$

Bei der Berechnung der Trägerfrequenz geht man von einer Konstanten in der sogenannten Frequenz-Justage patientenspezifisch gemessenen Resonanzfrequenz $f_0$ in der MR-Anlage aus. Weicht nun die Frequenz um $\delta f$ von $f_0$ ab, dann ist die Schicht demzufolge um $\delta z$ gegenüber dem gewünschten Abstand $z_0$ in Richtung des Schichtselektionsgradienten verschoben mit

$$\delta z = \left(\frac{2\pi}{\gamma}\right)\frac{\delta f}{G_z}. \qquad (6)$$

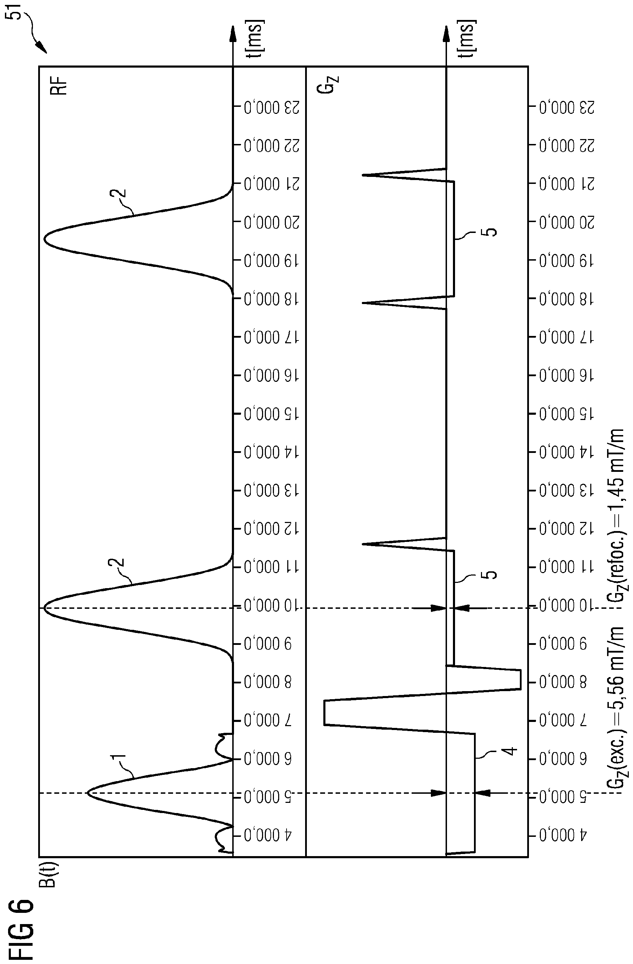

Aus Formel 6 folgt nun, dass das Absenken des Schichtselektionsgradienten des RF-Pulses um einen Faktor x diese Abweichung um einen Faktor x erhöht. Insbesondere (und das ist das eigentliche Problem) stimmt, sofern man zum Beispiel nun den Schichtselektionsgradienten der Refokussier-RF-Pulse absenkt, die Verschiebung der Refokussier-Schicht in Richtung des Schichtselektionsgradienten nicht mehr mit der Verschiebung der Anregungsschicht überein. Ein solches Absenken des Schichtselektionsgradienten ist in FIG 6 veranschaulicht.

FIG 6 zeigt einen Ausschnitt 51 eines Pulsdiagramms mit in einer ersten Zeile darstellten RF-Pulsen 1, 2 und in einer zweiten Zeile dargestellten Schichtselektionsgradienten 4, 5. Zunächst wird ein Anregungs-RF-Puls 1 und synchron dazu ein Schichtselektionsgradient mit einer relativ hohen Amplitude von 5,56 mT/m ausgespielt. Nach einer halben Echozeit wird ein Refokussier-RF-Puls und damit synchron ein Schichtselektionsgradient 5 mit einer deutlich niedrigeren Amplitude von 1,45 mT/m erzeugt. Infolge des im Vergleich zu dem ersten Gradienten 4 deutlich schwächeren Gradienten 5 ergibt sich eine "Verbreiterung" des Refokussier-RF-Pulses, wodurch eine dickere Schicht refokussiert wird.

Abhängig von der Bandbreite der RF-Pulse und der Größe der lokalen Off-Resonanz $\delta f$ kann das dazu führen, dass die angeregte Schicht und die refokussierte Schicht nicht mehr oder nur noch teilweise überlappen. Bei fehlender Überlappung werden keine Echosignale selbst für statische Spins generiert und es kommt zum totalen Signalverlust. Bei teilweiser Überlappung entspricht die effektive Schichtdicke dem Überlappungsbereich und das verlorene Signal wächst proportional mit Abnahme der effektiven Schichtdicke.

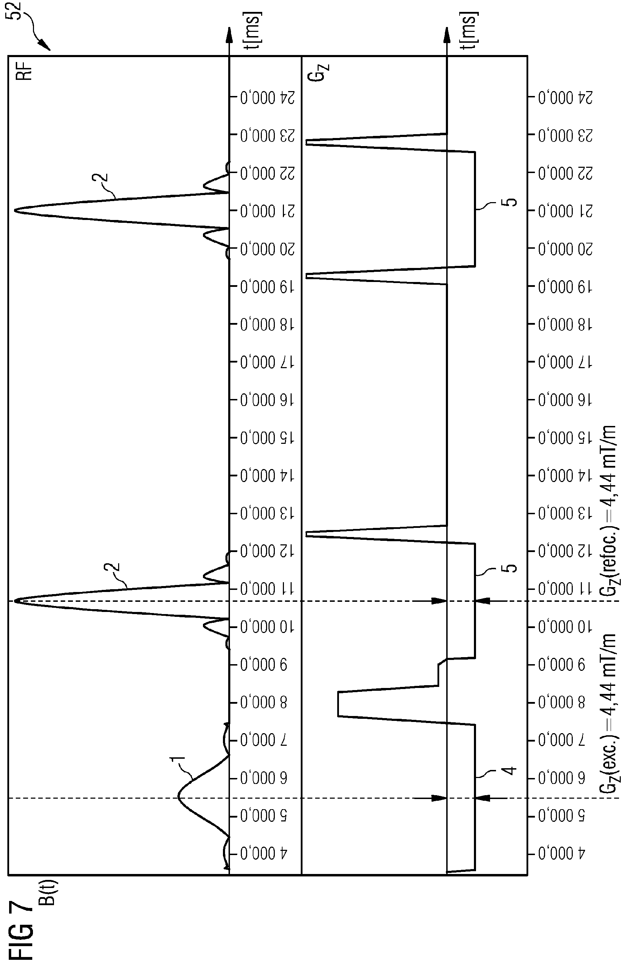

Um dies zu vermeiden, wird in einer bevorzugten Ausführungsform der Erfindung nicht der Schichtselektionsgradient des breiteren RF-Pulses bei ungeänderter Pulsform abgesenkt, sondern die Einhüllende des RF-Pulses oder die Dauer des RF-Pulses wird derart geändert, dass die RF-Bandbreite des breiteren RF-Pulses um einen Faktor x steigt. Gemäß Formel 3 steigt damit die Breite d des Refokussier-RF-Pulses um einen Faktor x, sofern man die Amplitude des zugehörigen Schichtselektionsgradienten ungeändert lässt. Unter der Annahme, dass in der ursprünglichen Sequenz der Anregungspuls und der Refokussier-RF-Puls eine annähernd gleiche Amplitude hatten, bleibt somit die Off-Resonanz-Insensibilität der Sequenz erhalten. Eine solche Vorgehensweise ist in FIG 7 illustriert.

FIG 7 zeigt einen Ausschnitt 52 eines Pulsdiagramms mit in einer ersten Zeile darstellten RF-Pulsen 1, 2 und in einer zweiten Zeile dargestellten Schichtselektionsgradienten 4, 5. Anders als bei der in FIG 6 gezeigten Darstellung 51 erfolgt bei der in FIG 7 dargestellten Pulssequenz eine Erhöhung der Schichtdicke durch eine Erhöhung der Bandbreite. Anders als bei der in FIG 6 dargestellten Pulssequenz bleibt die Amplitude der Schichtselektionsgradienten 4, 5 unverändert bei relativ hohen 4,44 mT/m.

Eine Methode, die Bandbreite eines RF-Pulses um einen Faktor x zu erhöhen, ist seine Dauer um einen Faktor x zu verkürzen bei ungeänderter Einhüllenden. Eine weitere Möglichkeit der in FIG 7 illustrierten Methode besteht darin, das sogenannte Bandbreite-Zeit-Produkt des Pulses um einen Faktor x zu erhöhen bei ungeänderter Dauer des Pulses. Dabei ist das dimensionslose Bandbreite-Zeit-Produkt definiert als das Produkt aus Dauer des Pulses mit seiner RF-Bandbreite. Die Änderung des Bandbreite-Zeitprodukts ändert im Allgemeinen die Einhüllende des RF-Pulses.

Dies sei am Beispiel eines SINC-Pulses näher erläutert:

Die Zeit-Abhängigkeit der Einhüllenden eines SINC-Pulses ist:

$$B_1(t) = \begin{cases} A_0 SINC\left(\frac{\pi t}{t_0}\right) = A_0 sin\left(\frac{\pi t}{t_0}\right) & -N_L t_0 \leq t \leq N_R t_0 \\ 0 & sonst \end{cases} . \qquad (7)$$

Dabei ist $A_0$ die Peak-Amplitude des RF-Pulses zur Zeit t = 0, $t_0$ ist die Dauer des halben zentralen Peaks und $N_L$ bzw. $N_R$ ist die Zahl der Nullstellen links bzw. rechts des zentralen Peaks.

Die Dauer T des RF-Pulses ist somit:

$$T = (N_L + N_R)t_0 . \qquad (8)$$

Die Bandbreite δf eines SINC-Pulses ist in guter Näherung gegeben durch:

$$\Delta f = \frac{1}{t_0} . \qquad (9)$$

Für das dimensionslose Bandbreite-Zeitprodukt gilt demnach:

$$\Delta f \, T = \frac{1}{t_0}(N_L + N_R)t_0 = (N_L + N_R) \qquad (10)$$

In FIG 5 ist die Einhüllende eines SINC-Pulses mit $N_L = N_R = 2$ dargestellt.

Erfindungsgemäßes Verkürzen der Dauer T des RF-Pulses um einen Faktor x entspricht also einem Verkürzen von $t_0$ um einen Faktor x bei ungeänderter Zahl der Nullstellen $N_L$ und $N_R$. Gemäß Formel 9 steigt damit die Bandbreite um einen Faktor x.

Die in FIG 7 veranschaulichte Erhöhung des Bandbreite-Zeit-Produkts um einen Faktor x (in FIG 7 um einen Faktor 3) bei ungeänderter Dauer T entspricht also einem Verkürzen von $t_0$ um einen Faktor x bei gleichzeitiger Erhöhung der Anzahl der Nullstellen ($N_L + N_R$) um einen Faktor x, derart, dass die Dauer T ungeändert bleibt.

Natürlich ist auch jede Zwischenlösung möglich, also eine teilweise Verkürzung der RF-Pulse und eine Erhöhung des Bandbreite-Zeitprodukts. Entscheidend ist bei dieser Variante lediglich, dass die Amplitude der Schichtselektionsgradienten von Anregungs- und Refokussier-RF-Pulsen annähernd gleich ist, um eine Off-Resonanz-Unempfindlichkeit der Sequenz zu erreichen.

Das erfindungsgemäße Erhöhen des Bandbreite-Zeit-Produkts hat zusätzlich den Vorteil, dass sich dadurch in der Regel das Schichtprofil verbessert, womit sich das Übersprechen der Schichten verringert. Ein gutes Schichtprofil erlaubt es, die notwendige Zahl der Verknüpfungen zu begrenzen.

Häufig wählt man die Amplitude der Schichtselektionsgradienten von Anregungs- und Refokussier-RF-Puls nicht exakt gleich, um einen sogenannten dritten Arm-Artefakt zu vermeiden. Bei Sequenzen von Siemens unterscheiden sich die Amplituden in der Regel um mindestens 20%. Eine erhöhte Off-Resonanz-Empfindlichkeit der Sequenz nimmt man dafür in Kauf. Deshalb ist es sinnvoll, nur zu fordern, dass die Schichtselektionsgradienten "annähernd" die gleiche Amplitude haben.

Bei der Verwendung von identischen SINC-Pulsen für Anregung und Refokussierung ist das Schichtprofil des Refokussier-RF-Pulses in Folge des höheren Flipwinkels verengt gegenüber dem Schichtprofil des Anregungspulses. Um dies zu kompensieren, senkt man die Amplitude des Schichtselektionsgradienten ab, bei Siemens-Sequenzen beispielsweise um einen empirischen Faktor 1,2. Dies ist nicht zu verwechseln mit der erfindungsgemäßen Verbreiterung des Refokussier-RF-Pulses, um einen Flussartefakt zu vermeiden bzw. zu verringern. Bei der erfindungsgemäßen Verbreiterung wird die Breite des Schichtprofils erhöht, d.h. die Halbwertsbreite (FWHM = full width at half maximum) wird erhöht. Der Faktor 1,2 im Stand der Technik bewirkt lediglich, dass die Breite des Schichtprofils von Anregungspuls und Refokussierpuls hinsichtlich der Halbwertsbreite annähernd gleich ist.

Es ist im Stand der Technik bekannt, dass eine Verbreiterung der Schichtdicke den "Time-of-Flight-Loss"-Effekt verringert. Gemeint ist die Verbreiterung von Anregungs- und Refokussier-RF-Pulsen, wie sie in der Regel über die Benutzerschnittstelle der MR-Anlage eingestellt werden kann. Diese Vorgehensweise ist mit einer entsprechenden Verringerung der Auflösung in Schichtselektionsrichtung verbunden. Die erfindungsgemäße Verbreiterung nur eines der beiden Pulse beeinflusst die Auflösung der Sequenz dagegen nicht.

Des Weiteren sei erwähnt, dass die Amplitude des Schichtselektionsgradienten, der während des Einstrahlens des Anregungspulses bzw. des Refokussier-RF-Pulses geschaltet wird, nicht notwendig während des Einstrahlens konstant ist. Häufig werden in der Bildgebung mit Turbo-Spin-Echo-Sequenzen sogenannte Variable-Rate-Pulse eingesetzt zur Reduktion der RF-Leistung, die von dem Patienten absorbiert wird. Dazu wird die RF-Amplitude in der Umgebung des Peaks des RF-Pulses abgesenkt. Es muss dann auch die Amplitude des Schichtselektionsgradienten entsprechend reduziert werden. Unter annähernd gleicher Amplitude der Schichtselektionsgradienten von Anregungspuls und Refokussier-RF-Puls sind bei der Verwendung von Variable-Rate-Pulsen annähernd gleiche Amplituden der Selektionsgradienten in der Umgebung des Peaks des jeweiligen RF-Pulses zu verstehen.

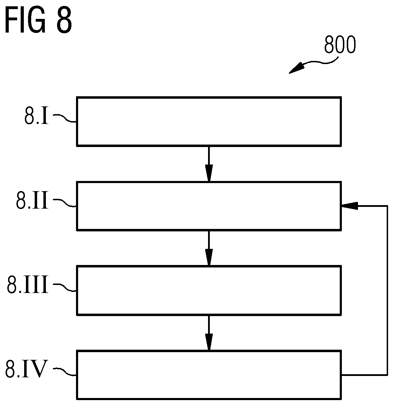

In FIG 8 ist ein Flussdiagramm 800 gezeigt, mit dem ein Verfahren zur Ansteuerung eines Magnetresonanzbildgebungssystems zur Erzeugung von Magnetresonanzbilddaten BD eines Untersuchungsobjekts P gemäß einem Ausführungsbeispiel der Erfindung veranschaulicht wird. Bei dem Verfahren wird eine Turbo-Spin-Echo-Sequenz angewendet. Zunächst wird bei dem Schritt 8.I ein Anregungs-RF-Puls ausgespielt. Der Wirkungsbereich des Anregungs-RF-Pulses wird hierbei mit Hilfe eines Schichtselektionsgradienten auf eine Schicht einer vorbestimmten Dicke d beschränkt.

Weiterhin erfolgt bei dem Schritt 8.II nach einer halben Echozeit ES/2 nach der Anregung ein Refokussierungsvorgang, bei dem ein RF-Refokussierungspuls eingestrahlt wird, mit dem ein Refokussierbereich beeinflusst wird. Der Refokussierungspuls dient dazu, einen nach der Anregung einsetzenden, die Quermagnetisierung betreffenden Dephasierungsprozess umzukehren. Die Breite des zu refokussierenden Bereichs wird über die Bandbreite des Refokussier-RF-Pulses und die Amplitude des Schichtselektionsgradienten bestimmt. Diese werden derart gewählt, dass die Breite der von dem Refokussier-RF-Puls erfassten Schicht größer als die Schichtdicke d ist. D.h., die Refokussierung wirkt auf eine dickere Schicht als die Anregung. Da aufgrund der Bewegung der Cerebrospinalflüssigkeit die angeregten Spins ihre Position nach einer halben Echozeit gewechselt haben und damit die Anregungsschicht zum Teil verlassen haben, bewirkt eine Verbreiterung der Refokussierschicht, dass auch solche CSF-Spins refokussiert werden, die zwar die Anregungsschicht verlassen haben, sich aber noch in der breiteren vom Refokussier-RF-Puls erfassten Schicht befinden. Sie liefern damit einen Signalbeitrag zum Auslesesignal.

Die räumliche Information für jede Schicht ist in einer 2-dimensionalen k-Raum-Datenmatrix kodiert. Im Beispiel der kartesischen Bildgebung mit einer Turbo-Spin-Echo-Sequenz wird z.B. mit jedem Echo eine k-Raum-Zeile gefüllt.

Nach einer Echozeit ES nach dem Anregungsvorgang erfolgt bei dem Schritt 8.III der Auslesevorgang zur Akquisition von Magnetresonanzrohdaten. Bei dem Auslesevorgang werden HF-Signale der sowohl angeregten als auch refokussierten Spins erfasst. Hierfür wird das Signal durch einen Auslesegradienten in Ausleserichtung mit einer Frequenz kodiert, wodurch eine räumliche Auflösung der auszulesenden Schicht in Ausleserichtung kodiert wird, und durch einen Phasenkodiergradienten in Phasenrichtung mit einer Phase beaufschlagt, wodurch eine Kodierung der auszulesenden Schicht in Phasenkodierrichtung erzielt wird. Die Ausleserichtung und die Phasenrichtung sind orthogonal zur Schichtrichtung orientiert. Weiterhin wird bei dem Schritt 8.IV die der auszulesenden Schicht aufgeprägte Phase mit Hilfe eines Phase-Rephasiergradienten wieder annuliert.

Anschließend wird zu dem Schritt 8.II zurückgekehrt und es erfolgt eine erneute Refokussierung der Schicht und bei dem Schritt 8.III ein erneutes Auslesen, wobei durch Änderung der aufgeprägten Phase eine andere k-Raum-Zeile der k-Raum-Matrix der auszulesenden Schicht kodiert wird und das entsprechende Signal ausgelesen wird. Die Schritte 8.II bis 8.IV werden mehrfach wiederholt. Es werden also mehrere k-Raum-Zeilen nach einer Anregung ausgelesen. Dadurch kann die Messzeit im Vergleich z.B. mit einer Spin-Echo-Sequenz, bei der nur eine einzelne k-Raum-Zeile pro Anregung ausgelesen wird, reduziert werden.

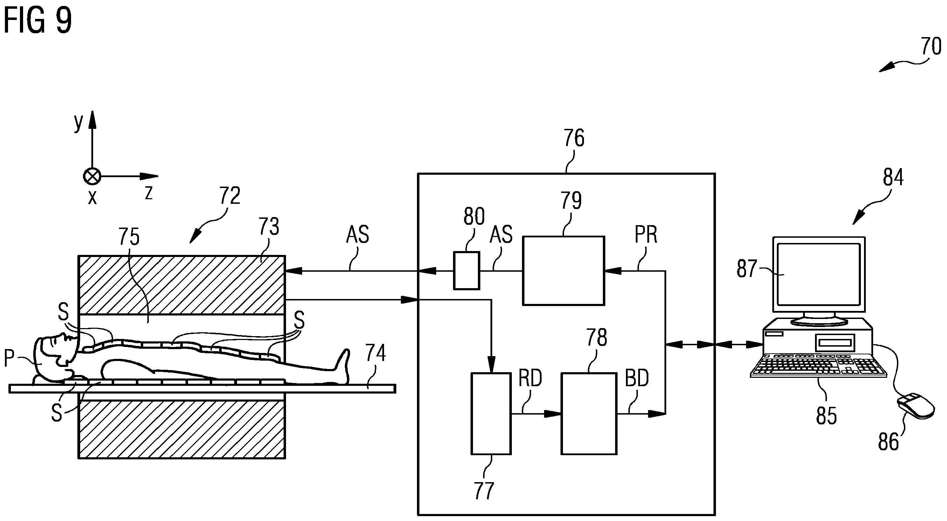

FIG 9 zeigt ein Ausführungsbeispiel einer erfindungsgemäßen Magnetresonanzanlage 70, welche in der Lage ist, nach dem erfindungsgemäßen Verfahren zu arbeiten. Kernstück dieser Magnetresonanzanlage 70 ist der Magnetresonanztomograph 72 selbst, in welchem ein Patient P auf einem Patientenlagerungstisch 74 (auch Patientenliege 74 genannt) in einem ringförmigen Grundfeldmagneten 73, welcher den Messraum 75 umschließt, positioniert wird. Auf und ggf. auch unter dem Patienten befindet sich beispielsweise eine Vielzahl von Lokalspulen S, auch Magnetresonanzspulen genannt.

Die Patientenliege 74 ist in Längsrichtung, d.h. entlang der Längsachse des Tomographen 72, verschiebbar. Diese Richtung wird in dem ebenfalls dargestellten Raumkoordinatensystem als z-Richtung bezeichnet. Innerhalb des Grundfeldmagneten befindet sich im Tomographen 72 eine nicht näher dargestellte Ganzkörperspule, mit der Hochfrequenzpulse ausgesendet und empfangen werden können. Außerdem weist der Tomograph 72 in üblicher, in FIG 9 nicht dargestellter Weise Gradientenspulen auf, um in jeder der Raumrichtungen x, y, z einen Magnetfeldgradienten anlegen zu können.

Angesteuert wird der Tomograph 72 von einer Steuereinrichtung 76, welche hier separat dargestellt ist. An die Steuereinrichtung 76 ist ein Terminal 84 angeschlossen. Dieses Terminal 84 weist einen Bildschirm 87, eine Tastatur 85 und ein Zeigegerät 86 für eine graphische Benutzeroberfläche, beispielsweise eine Maus 86 oder dergleichen auf.

Das Terminal 84 dient u. a. als Benutzerschnittstelle, über die ein Bediener die Steuereinrichtung 76 und damit den Tomographen 72 bedient. Sowohl die Steuereinrichtung 76 als auch das Terminal 84 können auch integraler Bestandteil des Tomographen 72 sein.

Das Magnetresonanzsystem 71 kann darüber hinaus auch alle weiteren üblichen Komponenten bzw. Merkmale solcher Systeme aufweisen, wie zum Beispiel Schnittstellen zum Anschluss eines Kommunikationsnetzes, beispielsweise eines Bildinformationssystems oder Ähnlichem. Alle diese Komponenten sind jedoch der besseren Übersichtlichkeit wegen in FIG 9 nicht dargestellt.

Über das Terminal 84 kann ein Bediener mit der Steuereinrichtung 76 kommunizieren und so für die Durchführung der gewünschten Messungen sorgen, indem beispielsweise der Tomograph 72 von der Steuereinrichtung 76 so angesteuert wird, dass die erforderlichen Hochfrequenzpulssequenzen durch die Hochfrequenz-Spulen ausgesendet werden und die Gradientenspulen in geeigneter Weise geschaltet werden. Über die Steuereinrichtung 76 werden auch die vom Tomographen kommenden, für die Bildgebung benötigten Rohdaten RD akquiriert. Hierzu weist die Steuereinrichtung 76 eine Rohdatenerfassungseinheit 77 auf, in der von dem Tomographen 72 kommende Messsignale in Rohdaten RD gewandelt werden. Beispielsweise wird dies durch eine Demodulierung und anschließende Digitalisierung der Messsignale erreicht. In einer Signalauswerteeinheit 78, bei der es sich z.B. um ein Modul der Steuereinrichtung 76 handeln kann, werden Rohdaten RD zu Bilddaten BD rekonstruiert. Die Bilddaten BD können beispielsweise auf dem Bildschirm 87 des Terminals 84 visualisiert werden und/oder in einem Speicher hinterlegt bzw. über ein Netzwerk versandt werden. Zur Ausführung des erfindungsgemäßen Verfahrens weist die Steuereinrichtung 76 eine Ansteuersequenz-Ermittlungseinheit 79 auf, mit der eine Ansteuersequenz AS ermittelt wird, welche zum Beispiel die in FIG 3 dargestellte Pulssequenz 30 umfasst. Beispielsweise empfängt die Ansteuersequenz-Ermittlungseinheit 79 von dem Terminal 84 Protokolldaten PR, welche vorbestimmte Parameterwerte einer zu ermittelnden Pulssequenz 30 aufweisen. Weiterhin umfasst die Steuereinrichtung 76 auch eine Ansteuersequenz-Erzeugungseinheit 80, welche dazu eingerichtet ist, eine Ansteuersequenz AS, umfassend die erfindungsgemäße Pulssequenz 30, auf dem Magnetresonanztomographen 72 auszuspielen, so dass das erfindungsgemäße Verfahren zur Ansteuerung eines Magnetresonanzbildgebungssystems zur Erzeugung von Magnetresonanzbilddaten BD eines Untersuchungsobjekts P ausgeführt wird.

Die zur Umsetzung der Erfindung in einem Magnetresonanzsystem 71 erforderlichen Komponenten wie die Rohdatenerfassungseinheit 77, die Signalauswerteeinheit 78, die Ansteuersequenz-Ermittlungseinheit 79 oder die Ansteuersequenz-Erzeugungseinheit 80 können zumindest teilweise oder auch vollständig in Form von Softwarekomponenten erstellt werden. Übliche Magnetresonanzsysteme weisen ohnehin programmierbare Steuereinrichtungen auf, so dass auf diese Weise die Erfindung bevorzugt mit Hilfe von geeigneter Steuersoftware realisierbar ist. D. h. es wird ein entsprechendes Computerprogramm direkt in den Speicher einer programmierbaren Steuereinrichtung 76 des betreffenden Magnetresonanzsystems 71 geladen, welches Programmcode-Mittel aufweist, um das erfindungsgemäße Verfahren durchzuführen. Auf diese Weise sind auch bereits existierende Magnetresonanzsysteme einfach und kostengünstig nachrüstbar.

Insbesondere ist es möglich, dass einige der Komponenten auch als Unterroutinen in bereits in der Steuereinrichtung 76 vorhandenen Komponenten realisiert sind bzw. dass vorhandene Komponenten für den erfindungsgemäßen Zweck mitverwendet werden. Dies betrifft beispielsweise die Ansteuersequenz-Ermittlungseinheit 79, die zum Beispiel in einer in einer existierenden Steuereinrichtung 76 bereits vorhandenen Ansteuersequenz-Erzeugungseinheit implementiert werden kann, welche dazu bestimmt ist, die Hochfrequenzspulen, Gradientenspulen oder sonstigen Komponenten im Tomographen in geeigneter Weise zur Durchführung einer üblichen bildgebenden Messung anzusteuern.

Es wird abschließend noch einmal darauf hingewiesen, dass es sich bei den vorbeschriebenen Verfahren, Pulssequenzen und Vorrichtungen lediglich um bevorzugte Ausführungsbeispiele der Erfindung handelt und dass die Erfindung vom Fachmann variiert werden kann, ohne den Bereich der Erfindung zu verlassen, soweit er durch die Ansprüche vorgegeben ist. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können.

## Patentansprüche

1. Verfahren zur Ansteuerung eines Magnetresonanzbildgebungssystems zur Erzeugung von Magnetresonanzbilddaten (BD) eines Untersuchungsobjekts (P), bei dem Magnetresonanzrohdaten (RD) erfasst werden, aufweisend mindestens eine Spin-Echo oder Turbo-Spin-Echo-Pulssequenz mit

   - einem Anregungsvorgang, wobei ein RF-Anregungspuls (1) eingestrahlt wird, mit dem ein Bereich, der einen abzubildenden Bereich enthält, angeregt wird und der angeregte Bereich durch einen Selektionsgradienten (4) definiert wird,

- einem Refokussierungsvorgang, bei dem ein RF-Refokussierungspuls (2) eingestrahlt wird, mit dem ein Refokussierbereich beeinflusst wird, der den abzubildenden Bereich zumindest teilweise umfasst, und der zu refokussierende Bereich mit mindestens einem Selektionsgradienten (5) definiert wird,
- einem Auslesevorgang zur Akquisition von Magnetresonanzrohdaten (RD), welcher das Empfangen von HF-Signalen (3) umfasst,

wobei die räumliche Ausdehnung des Anregungsbereichs signifikant verschieden von der räumlichen Ausdehnung des Refokussierbereichs gewählt wird.

2. Verfahren nach Anspruch 1, wobei die Ausdehnung des Refokussierbereichs größer gewählt wird als die Ausdehnung des Anregungsbereichs.

3. Verfahren nach Anspruch 1, wobei für den Fall einer Spin-Echo-Sequenz die Ausdehnung des Anregungsbereichs größer gewählt wird als die Ausdehnung des Refokussierbereichs.

4. Verfahren nach Anspruch 1, wobei der angeregte Bereich eine Anregungsschicht, welche durch einen Schichtselektionsgradienten (4) definiert wird, umfasst und der Refokussierbereich eine Refokussierschicht, welche durch einen Schichtselektionsgradienten (5) definiert wird, umfasst, wobei die räumliche Schichtdicke ($d_{exc}$) der Anregungsschicht signifikant verschieden von der Schichtdicke ($d_{refoc}$) der Refokussierschicht gewählt wird.

5. Verfahren nach Anspruch 4, wobei die Refokussierschicht dicker als die Anregungsschicht gewählt wird.

6. Verfahren nach Anspruch 4, wobei für den Fall einer Spin-Echo-Sequenz die Anregungsschicht dicker als die Refokussierschicht gewählt wird.

7. Verfahren nach einem der Ansprüche 4 bis 6, wobei die Dicke der dünneren der beiden Schichten gleich einer vom Anwender vorgegebenen Schichtdicke (d) ist.

8. Verfahren nach einem der Ansprüche 4 bis 7, wobei der Pulsparameter des Anregungspulses (1) und/oder des Refokussier-RF-Pulses (2) derart angepasst werden, dass die Schichtselektionsgradienten (4, 5) beider RF-Pulse (1, 2) annähernd die gleiche Amplitude haben.

9. Verfahren nach Anspruch 8, wobei die Pulsparameter des breiteren RF-Pulses (1, 2) derart angepasst werden, dass die Schichtselektionsgradienten (4, 5) beider RF-Pulse (1, 2) annähernd die gleiche Amplitude haben.

10. Verfahren nach einem der Ansprüche 4 bis 9, wobei ein Gradienten-Schema in Schichtselektionsrichtung gewählt wird, dessen erstes Moment in der zeitlichen Mitte der Refokussier-RF-Pulse (2) Null ist.

11. Verfahren nach Anspruch 10, wobei ein Gradientenschema in Schichtselektionsrichtung gewählt wird, dessen erstes Moment während des Auslesevorgangs Null ist.

12. Ansteuersequenz zur Ansteuerung eines Magnetresonanzbildgebungssystems, aufweisend:

- einen RF-Anregungspuls (1), mit dem ein Bereich der einen abzubildenden Bereich enthält, angeregt wird,
- einen ersten Schichtselektionsgradienten (4), mit dem der angeregte Bereich definiert wird,
- einen RF-Refokussierungspuls (2), mit dem ein Refokussierbereich beeinflusst wird,
- einen zweiten Schichtselektionsgradienten (5), mit dem der Refokussierbereich definiert wird,
- ein Auslesemodul (12) zur Akquisition von Magnetresonanzrohdaten,

wobei die räumliche Ausdehnung des Anregungsbereichs signifikant verschieden von der räumlichen Ausdehnung des Refokussierbereichs gewählt wird.

13. Magnetresonanzbildgebungssystem (70), umfassend eine Steuereinrichtung (76), welche zur Steuerung des Magnetresonanzbildgebungssystems (70) unter Nutzung eines Verfahrens nach einem der Ansprüche 1 bis 11 ausgebildet ist.

14. Computerprogrammprodukt mit einem Computerprogramm, welches direkt in eine Speichereinrichtung einer Steuereinrichtung (76) eines Magnetresonanzbildgebungssystems (70) ladbar ist, mit Programmabschnitten, um alle Schritte des Verfahrens nach einem der Ansprüche 1 bis 11 auszuführen, wenn das Computerprogramm in der Steuereinrichtung (76) des Magnetresonanzbildgebungssystems ausgeführt wird.

15. Computerlesbares Medium, auf welchem von einer Rechnereinheit eines Magnetresonanzbildgebungssystems (70) einlesbare und ausführbare Programmabschnitte gespeichert sind, um alle Schritte des Verfahrens nach einem der Ansprüche 1 bis 11 auszuführen, wenn die Programmabschnitte von der Rechnereinheit ausgeführt werden.

## FIG 1

FIG 2

$d = d_{exc}$

$\dfrac{ES}{2}$

$d = d_{refoc}$

$ES$

$d = d_{refoc}$

FIG 3

# FIG 4

FIG 5

FIG 6

$G_Z(exc.)=5,56$ mT/m   $G_Z(refoc.)=1,45$ mT/m

EP 3 839 545 A1

FIG 7

# FIG 8

800

| | |
|---|---|
| 8.I | |
| 8.II | |
| 8.III | |
| 8.IV | |

# FIG 9

EP 3 839 545 A1

Europäisches
Patentamt

European
Patent Office

Office européen
des brevets

**EUROPÄISCHER RECHERCHENBERICHT**

Nummer der Anmeldung

EP 19 21 6974

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | MAIER S E: "Slab scan diffusion imaging", MAGNETIC RESONANCE IN MEDICINE, JOHN WILEY & SONS, INC, US, Bd. 46, Nr. 6, 1. Dezember 2001 (2001-12-01), Seiten 1136-1143, XP002232392, ISSN: 0740-3194, DOI: 10.1002/MRM.1310 * das ganze Dokument * ----- | 1,3,4, 6-15 | INV. G01R33/483 G01R33/561 G01R33/565 |
| X | CONSTABLE R T ET AL: "Factors influencing contrast in fast spin-echo MR imaging", MAGNETIC RESONANCE IMAGING, ELSEVIER SCIENCE, TARRYTOWN, NY, US, Bd. 10, Nr. 4, 1. Januar 1992 (1992-01-01) , Seiten 497-511, XP026425127, ISSN: 0730-725X [gefunden am 1992-01-01] * Seite 497 - Seite 502 * ----- | 1,2,4,5, 7-15 | |
| X | OLA NORBECK, ENRICO AVVENTI, HENRIC RYDÉN , STEFAN SKARE: "Suppression of CSF-flow-artifacts for T1-w Spin-echo Spine Imaging", INTERNATIONAL SOCIETY FOR MAGNETIC RESONANCE IN MEDICINE, ISMRM, 2030 ADDISON STREET, 7TH FLOOR, BERKELEY, CA 94704 USA, Nr. 4672, 7. April 2017 (2017-04-07), XP040692240, * das ganze Dokument * ----- -/-- | 1,3,4, 6-15 | RECHERCHIERTE SACHGEBIETE (IPC) G01R |

Der vorliegende Recherchenbericht wurde für alle Patentansprüche erstellt

| Recherchenort | Abschlußdatum der Recherche | Prüfer |
|---|---|---|
| München | 13. März 2020 | Vanhaecke, Nicolas |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...........................................................................
& : Mitglied der gleichen Patentfamilie, übereinstimmendes Dokument

EPO FORM 1503 03.82 (P04C03)

Seite 1 von 2

Europäisches
Patentamt

European
Patent Office

Office européen
des brevets

# EUROPÄISCHER RECHERCHENBERICHT

Nummer der Anmeldung

EP 19 21 6974

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | GABY S PELL ET AL: "Optimized Clinical T2 Relaxometry With a Standard CPMG Sequence", JOURNAL OF MAGNETIC RESONANCE IMAGING, Bd. 23, Nr. 2, 13. Januar 2006 (2006-01-13), Seiten 248-252, XP055045719, DOI: 10.1002/jmri.20490 * das ganze Dokument * ----- | 1,2,4,5, 7-15 | |
| A,D | R. SCOTT HINKS ET AL: "Gradient moment nulling in fast spin echo", MAGNETIC RESONANCE IN MEDICINE., Bd. 32, Nr. 6, 1. Dezember 1994 (1994-12-01), Seiten 698-706, XP055559140, US ISSN: 0740-3194, DOI: 10.1002/mrm.1910320604 * Sektion "GMN in the Slice Selection Direction"; Seite 700 - Seite 701 * * Abbildungen 5c, 5d * ----- | 10,11 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| München | 13. März 2020 | Vanhaecke, Nicolas |

KATEGORIE DER GENANNTEN DOKUMENTE

X : von besonderer Bedeutung allein betrachtet
Y : von besonderer Bedeutung in Verbindung mit einer
 anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
 nach dem Anmeldedatum veröffentlicht worden ist
D : in der Anmeldung angeführtes Dokument
L : aus anderen Gründen angeführtes Dokument

.......................................................................................

& : Mitglied der gleichen Patentfamilie, übereinstimmendes
 Dokument

EPO FORM 1503 03.82 (P04C03)

Seite 2 von 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **CHRISTOPHER LISANTI et al.** *Normal MRI Appearance and Motion-Related Phenomena of CSF,* Marz 2007, vol. 188, 716-725

- **R. SCOTT HINK ; TODD CONSTABLE.** Gradient Moment Nulling in Fast Spin Echo. *Zeitschrift MRM,* 1994, vol. 32, 698-706